# EUROPÄISCHE PATENTSCHRIFT

(11) **EP 2 873 309 B1**
(45) Veröffentlichungstag und Bekanntmachung des Hinweises auf die Patenterteilung: **06.01.2021**
(21) Anmeldenummer: 13734072.5
(22) Anmeldetag: 04.07.2013
(51) Int. Cl.: H05K 1/11, H05K 1/02, H05K 3/34

(54) **LEITERPLATTE MIT EINER LÖTMITTEL FÜHRENDEN KAPILLARE**
PRINTED CIRCUIT BOARD HAVING A SOLDER-GUIDING CAPILLARY
CARTE DE CIRCUITS IMPRIMÉS POURVUE D'UN CAPILLAIRE GUIDANT UN AGENT DE SOUDAGE

(30) Priorität: 11.07.2012 DE 102012212087
(43) Veröffentlichungstag der Anmeldung: 20.05.2015
(73) Patentinhaber: Robert Bosch GmbH, 70442 Stuttgart (DE)
(72) Erfinder: SCHMITT, Michael, I-70026 Modugno (IT); CARLE, Wolfgang, 72820 Sonnenbuehl-Erpfingen (DE)
(86) Internationale Anmeldenummer: PCT/EP2013/064094
(87) Internationale Veröffentlichungsnummer: WO 2014/009234

(56) Entgegenhaltungen:
- EP-A1- 2 334 158
- DE-A1- 19 814 428
- DE-A1-102008 014 742
- US-A- 5 410 449
- US-A- 5 446 244
- US-A- 5 707 714
- US-A1- 2006 231 953
- US-A1- 2007 221 398
- US-A1- 2010 206 626

## Beschreibung

### Stand der Technik

Die Erfindung betrifft eine Leiterplatte umfassend wenigstens ein Substrat und eine mit dem Substrat verbundene elektrisch leitfähige Schicht. Bevorzugt ist durch die elektrisch leitfähige Schicht wenigstens eine Leiterbahn ausgebildet. Die Leiterplatte weist wenigstens ein Bauelement auf, wobei das Bauelement wenigstens einen elektrischen Anschluss aufweist, welcher mittels eines Lotmittels mit einem Kontaktbereich der elektrisch leitfähigen Schicht, insbesondere der Leiterbahn, elektrisch verbunden ist.

Bei mit einer Leiterplatte mittels eines Lotmittels verbundenen Bauelementen, insbesondere BGA-Bauelementen (BGA = Ball-Grid-Array) oder LGA-Bauelementen (LGA = Land-Grid-Array), besteht das Problem, dass der elektrische Anschluss, welcher auf einer der Leiterplatte zugewandten Unterseite des Bauelements angeordnet ist und mit der elektrisch leitfähigen Schicht, insbesondere einer Leiterbahn mittels Löten, verbunden ist, zwischen einem Gehäuse des Bauelements und der Leiterplatte angeordnet ist. Die Lötstelle ist so durch das Gehäuse des Bauelements verdeckt. Soll die Lötstelle kontrolliert werden, so kann dies bisher nur durch eine Röntgenkontrolle erfolgen.

In der Offenlegungsschrift US 2007/221398 A1 sind Kanäle als Gaspfade in einer Leiterbahn gezeigt, durch welche zwischen einem Bauelement und einer Leiterplatte eingeschlossenes Gas abgeführt werden kann. Die Gaspfade erstrecken über eine Begrenzung des Bauelements hinaus, haben jedoch keinen Kontakt zum Lotmittel.

Die Offenlegungsschrift US 5 446 244 A offenbart einen Spalt in der Leiterbahn außerhalb einer Begrenzung eines Bauelements, welcher mit Lotpaste bedruckt geschlossen ist und beim Verlöten das Lotmittel vom Spalt weggezogen und zur Lötstelle geführt wird. Dabei wird ein den Spalt bedeckendes Lotmittel als Indikator für eine fehlerhafte Lötstelle erkannt.

Die Offenlegungsschrift DE 10 2008 014 742 A1 zeigt eine durch ein Via in der Leiterplatte gebildete Kapillare, welche Lotmittel von dem Anschluss zwischen dem Bauelement und der Leiterplatte quer zu einer flachen Erstreckung der Leiterplatte durch die Leiterplatte hindurchführt. Der Verschluss der Kapillare kann dabei auf einer zu dem Bauelement gegenüberliegenden Seite optisch erfasst werden.

### Offenbarung der Erfindung

Die Erfindung ist insbesondere dadurch gekennzeichnet, dass sich der elektrische Anschluss des Bauelements und der Kontaktbereich wenigstens teilweise oder überwiegend oder ausschließlich zwischen dem Bauelement und dem Substrat der Leiterplatte der eingangs genannten Art erstreckt. Die Leiterbahn weist ausgehend von dem Kontaktbereich eine das Lotmittel führende Kapillare auf, wobei sich die Kapillare über eine Begrenzung des Bauelements, insbesondere eines Gehäuses des Bauelements, hinaus erstreckt. Dabei erstreckt sich die Kapillare über eine Projektionslinie einer Projektion des Bauelements, insbesondere des Gehäuses des Bauelements, auf die Leiterplatte hinaus.

Weiter erstreckt sich die das Lotmittel führende Kapillare derart über die Begrenzung des Bauelements hinaus, dass das über die Begrenzung - insbesondere seitlich des Bauelements - hinausgeführte Lotmittel in einer Aufsicht auf die Leiterplatte erfasst werden kann.

Beispielsweise kann das hinausgeführte Lotmittel in einer Aufsicht mittels elektromagnetischen Strahlen, beispielsweise mittels einer Erfassungsvorrichtung, umfassend eine Kamera und einen Sender für die elektromagnetischen Strahlen, erfasst werden. Dadurch kann vorteilhaft mittels der Erfassungsvorrichtung eine Qualitätskontrolle der Leiterplatte durchgeführt werden und in Abhängigkeit eines Erfassungsergebnisses das Vorhandensein des in der Kapillare seitlich über die Begrenzung des Bauelements hinausgeführten Lotmittels erfasst werden.

Weiter kann in Abhängigkeit des Erfassens des seitlich hinausgeführten Lotmittels ein die Qualität der Leiterplatte repräsentierendes Ausgangssignal durch die Erfassungsvorrichtung erzeugt werden, welches die Qualität der Lötstelle der Leiterplatte repräsentiert. Beispielsweise kann die Erfassungsvorrichtung ausgebildet sein, ein i.-O.-Signal (i.O. = in Ordnung) oder ein n.-i.-O.-Signal (n.i.O. = nicht in Ordnung) zu erzeugen.

Mittels der so ausgebildeten Leiterplatte kann nämlich von außen in einer Aufsicht einfach erfassbar dargestellt werden, ob die Lötstelle zwischen dem Bauelement und der Leiterplatte, welche durch das Bauelement selbst verdeckt ist, den elektrischen Anschluss des Bauelements mit der elektrisch leitfähigen Schicht elektrisch leitend verbindet. Wenn beispielsweise eine Lötperle, welche mit dem elektrischen Anschluss des Bauelements vor einem Verlöten in einem Reflow-Ofen verbunden ist, beim Verlöten in dem Reflow-Ofen nicht wie vorgesehen schmilzt und den elektrischen Anschluss mit der elektrisch leitfähigen Schicht verbindet, so kann die Kapillare auch keinen Teil des Lotmittels in geschmolzener Form durch den Kapillareffekt nach außen seitlich über die Begrenzung des Bauelements hinausführen. Das Vorhandensein des mittels der Kapillare seitlich über die Begrenzung des Bauelements hinausgeführten Lotes ist somit ein Beweisanzeichen für eine zwischen dem Bauelement und der Leiterplatte befindliche, elektrisch leitfähige Lötstelle zwischen dem elektrischen Anschluss und der elektrisch leitfähigen Schicht.

In einer bevorzugten Ausführungsform ist die Kapillare durch eine sich längs erstreckende Vertiefung oder Ausnehmung in der elektrisch leitfähigen Schicht, insbesondere der Leiterbahn, gebildet. So kann die Kapillare vorteilhaft aufwandsgünstig mittels eines Ätzverfahrens zusammen mit der Leiterbahnstruktur der Leiterplatte erzeugt werden. Die Ausnehmung ist bevorzugt als Durchbruch ausgebildet.

Bevorzugt ist durch die sich längs erstreckende Vertiefung oder die sich längs erstreckende Ausnehmung eine Art Rinne gebildet, welche das Lotmittel mittels Kapillareffekt führen kann. Die elektrisch leitfähige Schicht ist bevorzugt eine Kupferschicht. Das Lotmittel weist bevorzugt Zinn auf. Der elektrische Anschluss des Bauelements weist bevorzugt als elektrischen Leiter Kupfer auf, weiter bevorzugt eine Nickel, Silber oder Gold aufweisende Oberflächenschicht auf.

Bevorzugt ist die elektrisch leitfähige Schicht, insbesondere die Leiterbahn in einem die Kapillare umgebenden Bereich mit einem eine Oberflächenspannung des Lotmittels herabsetzenden Netzmittel, insbesondere einem Lötstopp-Lack beschichtet. So kann das geschmolzene Lot vorteilhaft mittels des Kapillareffekts entlang der Vertiefung oder der Ausnehmung geführt werden, ohne durch die Oberflächenspannung an der Oberfläche der elektrisch leitfähigen Schicht bzw. der Leiterbahn eine das Fortbewegen in der Vertiefung bremsende Kraft zu erfahren.

In einer vorteilhaften Ausführungsform der Leiterplatte erstreckt sich die Kapillare nur teilweise in den Kontaktbereich hinein. Beispielsweise kann eine Lötperle, welche an einem Anschluss des Bauelements haftet, mit einem Bereich eines äußeren Endes die Kapillare, insbesondere einen Endabschnitt der Kapillare, berühren und auf diesen aufgesetzt werden. Das Lot kann so in dem Kontaktbereich, welcher keine Kapillare aufweist, die elektrische Verbindung zwischen dem elektrischen Anschluss und der elektrisch leitfähigen Schicht bilden. Die Kapillare führt in dieser Ausführungsform nur soweit an die Lötperle heran, dass beim Aufschmelzen der Lötperle oder einer Lotpaste geschmolzenes Lot in die Kapillare hinein dringen kann und von einem Bereich des Hineindringens entlang der Kapillare in einen Außenbereich seitlich über eine Begrenzung des Bauelements - bezogen auf eine Aufsicht auf die Leiterplatte - geführt werden kann.

In einer bevorzugten Ausführungsform der Leiterplatte weist die Kapillare von dem Kontaktbereich weg führend einen die Kapillarwirkung verringernden Längsabschnitt und/oder ein die Kapillarwirkung stoppendes Ende auf. So kann vorteilhaft sichergestellt werden, dass während eines Aufschmelzens des Lotes im Reflow-Ofen nur ein kleiner Teil des Lotes in der Kapillare von der Lötstelle abgesaugt wird. Auf diese Weise bleibt an der Lötstelle noch ausreichend Lot, um eine sichere, elektrisch leitfähige Lötverbindung zwischen dem elektrischen Anschluss und der elektrisch leitfähigen Schicht im Kontaktbereich zu erzeugen.

In einer bevorzugten Ausführungsform ist der die Kapillarwirkung verringernde Längsabschnitt durch eine Ausnehmung in der elektrisch leitfähigen Schicht gebildet, die eine größere Breitenabmessung aufweist als ein zu dem Kontaktbereich führender Längsabschnitt der Kapillare. So kann die Kapillarwirkung vorteilhaft mittels einer Geometrie der Leiterbahn, bevorzugt in einer Leiterplattenebene der Leiterplatte, erzeugt sein.

In einer bevorzugten Ausführungsform weist eine die Ausnehmung bildende Kapillare eine kleinere Breitenabmessung quer zur Längserstreckung der Kapillare auf, als eine Dickenabmessung der elektrisch leitfähigen Schicht, insbesondere der Leiterbahn. Dadurch kann vorteilhaft eine noch ausreichende Kapillarwirkung erzeugt werden. Bevorzugt beträgt die Breitenabmessung der Kapillare in einer Ebene der Leiterplatte zwischen 100 und 300 µm, bevorzugt 200 µm.

In einer bevorzugten Ausführungsform ist das Substrat im Bereich der Kapillare lumineszierend ausgebildet, sodass eine von dem Substrat durch die Kapillare tretende Lumineszenzstrahlung in einer Aufsicht auf die Leiterplatte erfasst werden kann. Beispielsweise kann die Leiterplatte zum Kontrollieren einer Qualität der Lötstellen, welche zwischen dem Bauelement und der Leiterplatte angeordnet sind, mittels elektromagnetischen Strahlen, beispielsweise sichtbarem Licht bestrahlt werden. Führt die Kapillare in einem Längsabschnitt seitlich der Begrenzung des Bauelements kein Lot, so können die elektromagnetischen Strahlen durch die Kapillare hindurch bis hin zur Substratschicht vordringen, um dort auf den lumineszierend ausgebildeten Bereich des Substrates treffen. Von dort wird Lumineszenzstrahlung, insbesondere Fluoreszenzstrahlung oder Phosphoreszenzstrahlung erzeugt, welche durch die Kapillare hindurch nach außen zurück reflektiert wird. Die Lumineszenzstrahlung kann beispielsweise mittels der zuvor erwähnten Erfassungsvorrichtung oder mittels einem menschlichen Auge zur Qualitätskontrolle der Leiterplatte erfasst werden.

In einer bevorzugten Ausführungsform weist das Substrat im Bereich der Kapillare eine von einem menschlichen Auge wahrnehmbare Farbe auf, die sich von einer Farbe der Leiterplatte, insbesondere von einer Farbe eines die Leiterplatte wenigstens teilweise bedeckenden Lötstopplackes, unterscheidet. Der Lötstopplack weist beispielsweise eine dunkle Farbe, insbesondere eine grüne Farbe auf. Die Farbe des Substrats im Bereich der Kapillare ist beispielsweise eine Signalfarbe, insbesondere gelb, rot, orange, bevorzugt als fluoreszierend ausgebildete Neonfarbe. So kann vorteilhaft bereits mittels einer Inaugenscheinnahme durch ein menschliches Auge eine Leiterplatte zu Qualitätssicherungszwecken auf fehlerhafte Lötstellen zwischen Bauelementen und der Leiterplatte kontrolliert werden.

In einer anderen Ausführungsform ist das Substrat im Bereich der Kapillare phosphoreszierend ausgebildet. So kann vorteilhaft mittels eines menschlichen Auges auch noch ein sehr schmaler offener Spalt erfasst werden, welcher kein Lotmittel führt und auf eine defekte Lötstelle unter einem Bauelement hinweist. Dazu kann die Leiterplatte nach einem Verlöten mittels beispielsweise ultravioletter elektromagnetischer Strahlung bestrahlt werden. Die phosphoreszierenden Substratbereiche werden dadurch zum Selbstleuchten angeregt. Wenn die Leiterplatte anschließend im Dunkeln betrachtet wird, so kann ein punktweises Aufleuchten der phosphoreszierenden Substratbereiche durch die noch offenen, nicht mit Lot gefüllten Kapillaren leicht erfasst werden.

Die Erfindung betrifft auch ein Verfahren zum Verbinden wenigstens eines elektrischen Anschlusses eines Bauelements, insbesondere eines BGA- oder LGA-Bauelements, mit einer elektrisch leitfähigen Schicht in der Leiterplatte. Bei dem Verfahren wird das Bauelement, welches wenigstens einen elektrischen Anschluss auf einer der Leiterplatte zugewandten Unterseite aufweist mit der Unterseite auf eine Leiterplattenoberfläche aufgelegt. Dabei berührt ein mit dem elektrischen Anschluss verbundenes Lotmittel, insbesondere eine Lötperle oder Lotpaste, die elektrisch leitfähige Schicht.

In einem weiteren Verfahrensschritt wird die Leiterplatte zusammen mit dem Bauelement in einem Reflow-Ofen verlötet. Beim Verlöten des wenigstens einen elektrischen Anschlusses wird ein Teil des Lotmittels mittels Kapillarwirkung aus einem Raum zwischen dem Bauelement und der Leiterplatte derart herausgeführt, dass das herausgeführte Lotmittel in einer Aufsicht auf die Leiterplatte, insbesondere senkrecht auf die Leiterplatte, erfasst werden kann.

Die Erfindung wird nun im Folgenden anhand von Figuren und weiteren Ausführungsbeispielen erläutert. Weitere vorteilhafte Ausführungsvarianten ergeben sich aus den in den Figuren und in den abhängigen Ansprüchen beschriebenen Merkmalen.

Die zuvor beschriebene Kombination umfassend eine Leiterplatte und wenigstens ein mit der Leiterplatte zu verbindendes oder verbundenes Bauelement wird im Folgenden auch Verbindungsanordnung genannt.
Figur 1 zeigt ein Ausführungsbeispiel für eine Verbindungsanordnung mit einer Leiterplatte und einem Bauelement;
Figur 2 zeigt einen Teil der in Figur 1 dargestellten Verbindungsanordnung im Detail, wobei ein Lotmittel in eine Kapillare einfließt und teilweise in einer Aufsicht mittels einer Kamera erfasst oder mit einem menschlichen Auge gesehen werden kann;
Figur 3 zeigt ein Ausführungsbeispiel für eine Kapillare mit einem Längsabschnitt, welcher ausgebildet ist, einen Fluß des Lotmittels entlang der Kapillare zu stoppen;
Figur 4 zeigt einen Teil der in Figur 1 dargestellten Verbindungsanordnung im Detail in einer Schnittdarstellung, wobei ein Lotmittel in eine Kapillare eingeflossen ist und teilweise in einer Aufsicht mittels einer Kamera erfasst oder mit einem menschlichen Auge gesehen werden kann;
Figur 5 zeigt einen Teil der in Figur 1 dargestellten Verbindungsanordnung im Detail in einer Schnittdarstellung, wobei das Lotmittel nicht in die Kapillare eingeflossen ist und eine aus der offenen Kapillare austretende Lumineszenzstrahlung in einer Aufsicht mittels einer Kamera erfasst oder mit einem menschlichen Auge gesehen werden kann.

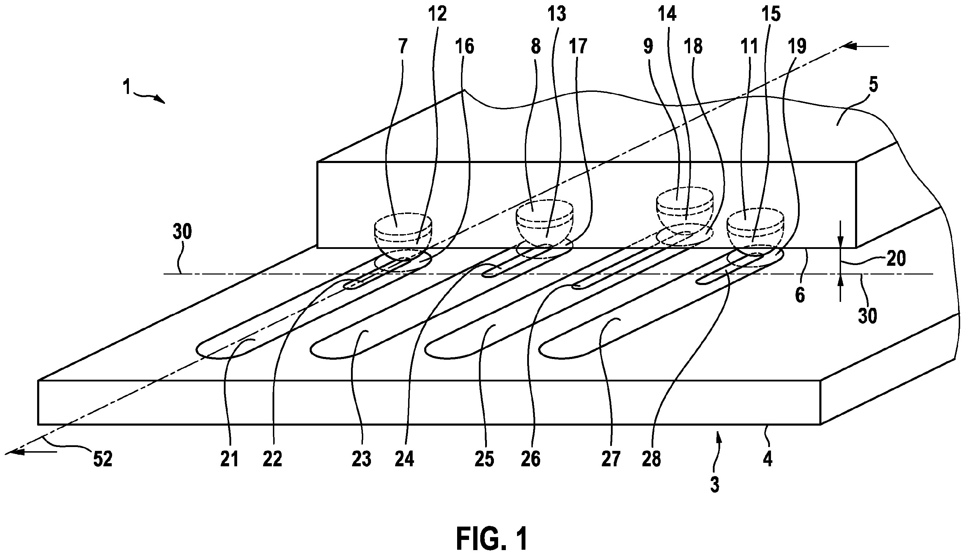

Figur 1 zeigt - schematisch - ein Ausführungsbeispiel für eine Verbindungsanordnung 1. Die Verbindungsanordnung 1 umfasst eine Leiterplatte 3, wobei die Leiterplatte 3 eine Substratschicht 4 und eine elektrisch leitfähige Schicht aufweist. Die elektrisch leitfähige Schicht ist in diesem Ausführungsbeispiel bereits mittels Ätzen in elektrisch leitfähige Leiterbahnen 21, 23, 25 und 27 geformt. Die Leiterbahn 21 weist eine sich längs erstreckende Ausnehmung auf, durch welche eine Kapillare 22 erzeugt ist. Die Leiterbahn 23 weist eine Kapillare 24 auf, die Leiterbahn 25 weist eine Kapillare 26 auf und die Leiterbahn 27 weist eine Kapillare 28 auf. Die Kapillaren 24, 26 und 28 sind jeweils als sich längserstreckende Ausnehmungen ausgebildet.

Die Leiterbahn 21 weist im Bereich eines Endabschnitts einen Kontaktbereich 16 auf, welcher einen Landebereich für einen elektrischen Anschluss 7 eines elektronischen Bauelements 5, beispielsweise einen Mikroprozessor bildet. Der elektrische Anschluss 7 ist in diesem Ausführungsbeispiel mit einem Lotmittel 12 verbunden, welches in diesem Ausführungsbeispiel als Lotperle ausgebildet ist. Das Bauelement 5 weist auch einen elektrischen Anschluss 8 mit einem Lotmittel 13, einem elektrischen Anschluss 9 mit einem Lotmittel 14 und einen elektrischen Anschluss 11 mit einem Lotmittel 15 auf. Die Leiterbahn 23 weist im Bereich eines Endes den Kontaktbereich 17 auf, wobei der Kontaktbereich 17 dem elektrischen Anschluss 8 gegenüberliegend angeordnet ist. Die Leiterbahn 25 weist im Bereich eines Endes einen Kontaktbereich 18 auf und die Leiterbahn 27 weist im Bereich eines Endes einen Kontaktbereich 19 auf. Das Bauelement 5 weist die elektrischen Anschlüsse 7, 8, 9 und 11 an einer Unterseite des Bauelements auf, welche einer Oberfläche der Leiterplatte 3, auf welcher die Leiterbahnen 21, 23, 25 und 27 angeordnet sind, gegenüberliegt. Die Unterseite des Bauelements 5 ist mittels eines Abstandes 20 von der Oberseite der Leiterplatte 3 beabstandet. Die Lotmittel 12, 13, 14 und 15 setzen jeweils auf den Landebereich der jeweils gegenüberliegenden Leiterbahn auf, wobei der Landebereich durch den jeweiligen Kontaktbereich der Leiterbahn gebildet ist. Die Kapillare 22 reicht in den Kontaktbereich 16 hinein, die Kapillare 24 reicht in den Kontaktbereich 17 und die Kapillare 28 reicht in den Kontaktbereich 19 hinein. Die Kapillaren 22, 24, 26 und 28 erstrecken sich jeweils beginnend von dem jeweiligen Kontaktbereich in einer Leiterplattenebene der Leiterplatte 3 über eine Begrenzung 6 des Bauelements 5 hinaus, welche in einer Projektion des Bauelements 5 auf die zuvor genannte Oberfläche der Leiterplatte 3 trifft.

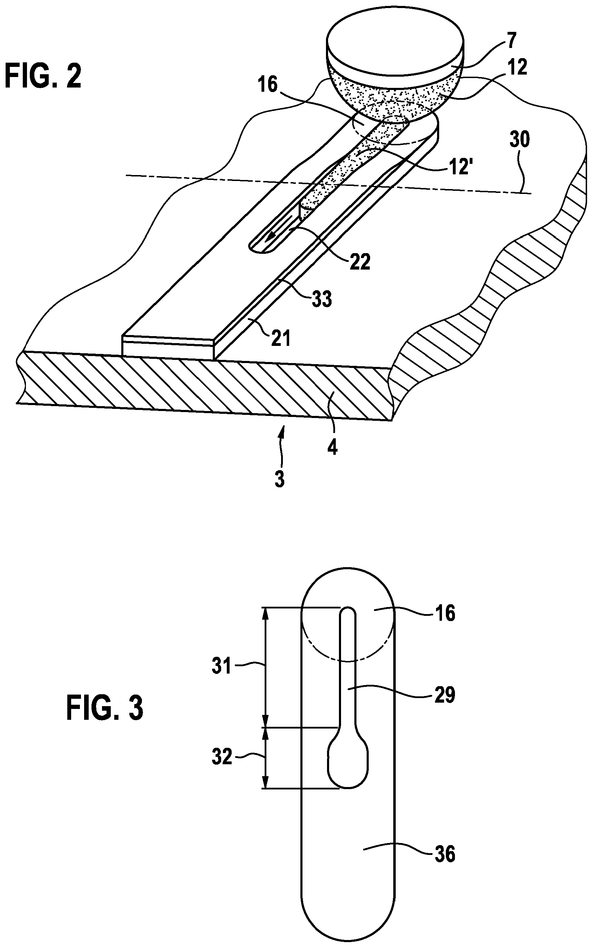

Wenn die Lotmittel 12, 13, 14 und 15 beim Erwärmen der Verbindungsanordnung 1 in einem Reflow-Lötofen schmelzen, kann ein Teil der Lotmittel von den jeweiligen Kapillaren aufgenommen und entlang einer Längserstreckung der Kapillare über die Projektionslinie 30 der Begrenzung 6 des Bauelements 5 hinausgeführt werden. Dies ist im Folgenden in Figur 2 näher detailliert dargestellt.

Figur 2 zeigt - schematisch - einen Abschnitt der in Figur 1 bereits gezeigten Leiterplatte 3. Dargestellt ist ein Abschnitt des Substrates 4, welches beispielsweise als faserverstärktes Epoxidharz gebildet ist. Dargestellt ist auch die elektrisch leitfähige Schicht, insbesondere die Leiterbahn 21, welche eine die Kapillare 22 bildende, sich längs erstreckende Ausnehmung aufweist. Der in Figur 1 bereits dargestellte Anschluss 7 des Bauelements 5 ist mit dem Lotmittel 12 verbunden und setzt auf den Kontaktbereich 16 der Leiterbahn 21 auf. Ein Teil des Lotmittels 12 ist bereits entlang der Längserstreckung der Kapillare 22 als geschmolzenes und von der Kapillare 22 aufgenommenes Lotmittel 12' von der Kapillare 22 aufgenommen worden. Das Lotmittel 12' ist bereits über die Projektionslinie 30 hinaus geflossen und kann so in einer Aufsicht auf die Leiterplatte 3 erfasst werden. Die Leiterbahn 21 ist im Ausführungsbeispiel der Figur 2 teilweise, ausgenommen des Landebereichs 16, mit einer Schicht Lötstopplack 33 beschichtet. Der Lötstopplack 33 bewirkt eine Reduzierung der Oberflächenspannung des geschmolzenen Lotmittels 12', so dass das geschmolzene Lotmittel 12' leicht in die Kapillare 22 hineingezogen werden kann.

Figur 3 zeigt - schematisch - eine Variante für eine Leiterbahn 36 mit einer Kapillare 29, welche von dem Kontaktbereich 16 wegführend einen die Kapillarwirkung verringernden Längsabschnitt 32 aufweist. Der Längsabschnitt 32 ist dadurch gebildet, dass die Kapillare quer zu ihrer Längserstreckung eine größere Breitenabmessung aufweist als im Bereich der Kapillare 29, der den Längsabschnitt 31 bildet.

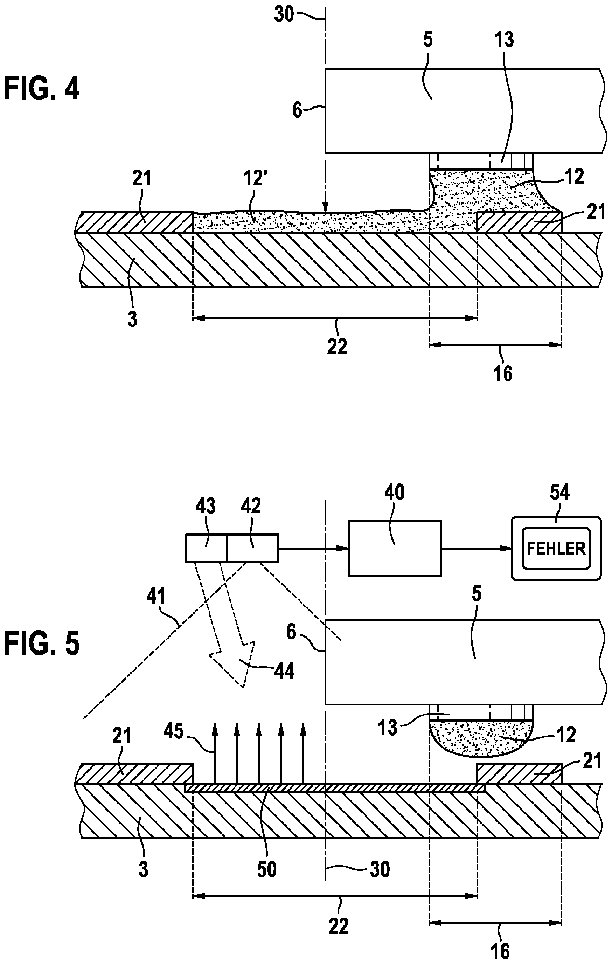

Figur 4 zeigt - schematisch - einen Abschnitt der in Figur 1 dargestellten Verbindungsanordnung mit dem Bauelement 5 und der Leiterplatte 3, welche jeweils abschnittsweise dargestellt sind. Figur 4 zeigt die in Figur 1 dargestellte Verbindungsanordnung 1 entlang einer in Figur 1 dargestellten Schnittlinie 52 in einer Schnittdarstellung.
Dargestellt ist auch die Projektionslinie 30 einer Projektion der Begrenzung 6 des Bauelements 5 auf die Leiterplatte 3. Die in Figur 1 dargestellte Kapillare 22 ist mit einem Teil 12' des Lotmittels 12 vollständig in Längsrichtung der Kapillare 22 ausgefüllt. Sichtbar ist, dass die Kapillare 22 sich in den Kontaktbereich 16 hinein erstreckt. Der Teil 12' des Lotmittels 12, welcher in die Kapillare 22 hinein gesaugt worden ist, zeigt an, dass das Lotmittel 12 geschmolzen ist und den elektrischen Anschluss 13 des Bauelements 5 mit der Leiterbahn 21 verbunden hat.

Figur 5 zeigt - schematisch - ein Ausführungsbeispiel für einen Teil der in Figur 1 bereits dargestellten Verbindungsanordnung, wobei das Lotmittel 12 nicht geschmolzen ist und die Leiterbahn 21 nicht kontaktiert. Der Kontaktbereich 16 der Leiterbahn 21 wird demnach nicht von dem elektrischen Anschluss 13 mittels des Lotmittels 12 kontaktiert.

Die Leiterplatte 3, insbesondere ein Substrat 4 der Leiterplatte 3 weist in diesem Ausführungsbeispiel im Bereich der Kapillare 22 eine lumineszierend ausgebildete Lumineszenzschicht 50 auf. Die Lumineszenzschicht 50 ist ausgebildet, in Abhängigkeit einer auf die Lumineszenzschicht 50 eintreffenden elektromagnetischen Strahlung 44 eine Lumineszenzstrahlung 45 auszusenden. Dargestellt ist auch eine Erfassungsvorrichtung 40, welche eingangsseitig mit einem Detektor 42 für die Lumineszenzstrahlen 45 und mit einem Sender 43 für elektromagnetische Strahlen 44 verbunden ist. Der Sender 43 für die elektromagnetischen Strahlen 44 ist ausgebildet, die elektromagnetischen Strahlen 44 zu erzeugen und in Richtung der Leiterplatte 3 auszusenden. Der Detektor 42 ist ausgebildet und angeordnet, die Lumineszenzstrahlen 45 in einem Erfassungsbereich 41 zu empfangen und ein Ausgangssignal, insbesondere einen die Verbindungsanordnung repräsentierenden Bilddatensatz zu erzeugen, wobei das Ausgangssignal die Lumineszenzstrahlen 45 bzw. ein Abbild der Verbindungsanordnung repräsentiert. Die Erfassungsvorrichtung 40 ist ausgangsseitig mit einem Display 54, insbesondere einem TFT-Display (TFT = Thin-Film-Transistor) verbunden. Die Erfassungsvorrichtung 40 ist ausgebildet, in Abhängigkeit des von dem Detektor 42 empfangenen Ausgangssignals eine Bildmustervergleich anhand abgespeicherter Bildmuster durchzuführen und in Abhängigkeit eines Vergleichsergebnisses des Bildmustervergleichs ein Ergebnissignal zu erzeugen und dieses ausgangsseitig auszugeben und an das Display 54 zu senden. Das Display 54 zeigt in diesem Ausführungsbeispiel ein n.-i.-O.-Signal als Ergebnissignal, repräsentiert durch den Schriftzug "Fehler", was einem Benutzer der Erfassungsvorrichtung signalisiert, dass das Lotmittel 12 - anders als in Figur 4 dargestellt - nach einem Erwärmen der Verbindungsanordnung in einem Reflow-Lötofen nicht ordnungsgemäß geschmolzen ist und den elektrischen Anschluss 13 nicht mit der Leiterbahn 21 elektrisch verbunden hat.

Die Erfassungsvorrichtung 40 weist beispielsweise einen Mikrocomputer oder einen Mikrocontroller auf. Die Erfassungsvorrichtung 40 ist beispielsweise ausgebildet, die fehlerhafte oder korrekte Lötverbindung zwischen dem elektrischen Anschluss 13 und der Leiterbahn 21 in Abhängigkeit des eingangsseitig empfangenen Bilddatensatzes zu erfassen und dazu eine Bilddatenverarbeitung, insbesondere den Bildmustervergleich, durchzuführen, und in Abhängigkeit des Erfassungsergebnisses ein i.-O.-Signal oder n.-i.-O.-Signal zu erzeugen und ausgangsseitig auszugeben.

## Patentansprüche

1. Leiterplatte (3) umfassend wenigstens ein Substrat (4) und eine mit dem Substrat (4) verbundene elektrisch leitfähige Schicht, wobei durch die elektrisch leitfähige Schicht wenigstens eine Leiterbahn (21, 23, 25, 27, 36) ausgebildet ist, und die Leiterplatte (3) wenigstens ein Bauelement (5) mit wenigstens einem elektrischen Anschluss (7, 8, 9, 11) aufweist, wobei der elektrische Anschluss (7, 8, 9, 11) mittels eines Lotmittels (12, 13, 14, 15) mit einem Kontaktbereich (16, 17, 18, 19) der Leiterbahn (21, 23, 25, 27, 36) elektrisch verbunden ist, wobei der elektrische Anschluss (7, 8, 9, 11) des Bauelements (5) und der Kontaktbereich (16, 17, 18, 19) sich wenigstens teilweise zwischen einem Bauelement (5) und dem Substrat (4) der Leiterplatte (3) erstreckt, wobei die Leiterbahn (21, 23, 25, 27) ausgehend von dem Kontaktbereich (16, 17, 18, 19) eine das Lotmittel (12, 13, 14, 15) führende Kapillare (22, 24, 26, 28, 29) aufweist, , wobei die Kapillare (22, 24, 26, 28, 29) ausgebildet ist, einen Teil des Lotmittels (12, 13, 14, 15) mittels Kapillarwirkung aus einem Raum zwischen dem Bauelement (5) und der Leiterplatte (3) derart herauszuführen, dass das herausgeführte Lotmittel (12') in einer senkrechten Aufsicht auf die Leiterplatte (3) erfasst werden kann, so dass ein Vorhandensein des mittels der Kapillare (22, 24, 26, 28, 29) hinausgeführten Lotmittels (12') eine zwischen dem Bauelement (5) und der Leiterplatte befindliche, elektrisch leitfähige Lötstelle zwischen dem elektrischen Anschluss (7, 8, 9, 11) und der elektrisch leitfähigen Schicht repräsentiert,
**dadurch gekennzeichnet, dass**
sich die das Lotmittel (12, 13, 14, 15) führende Kapillare (22, 24, 26, 28, 29) über eine Begrenzung (6) des Bauelements (5), nämlich eine Projektionslinie (30) einer Projektion des Bauelements (5) auf die Leiterplatte (3), hinauserstreckt und dabei Lotmittel (12') auch seitlich über die Begrenzung (6) des Bauelements (5) hinausgeführt ist.

2. Leiterplatte (3) nach Anspruch 1,
**dadurch gekennzeichnet, dass**
die Kapillare (22, 24, 26, 28, 29) durch eine sich längserstreckende Vertiefung oder Ausnehmung in der Leiterbahn (21, 23, 25, 27, 36) gebildet ist.

3. Leiterplatte (3) nach Anspruch 1 oder 2,
**dadurch gekennzeichnet, dass**
die Leiterbahn (21, 23, 25, 27, 36) in einem die Kapillare (22, 24, 26, 28, 29) umgebenden Bereich mit einem eine Oberflächenspannung des Lotmittels herabsetzenden Netzmittel, insbesondere einem Lötstopp-Lack (33) beschichtet ist.

4. Leiterplatte (3) nach einem der vorhergehenden Ansprüche,
**dadurch gekennzeichnet, dass**
die Kapillare (22, 24, 26, 28, 29) sich nur teilweise in den Kontaktbereich (16, 17, 18, 19) hineinerstreckt.

5. Leiterplatte (3) nach einem der vorhergehenden Ansprüche,
**dadurch gekennzeichnet, dass**
die Kapillare (22, 24, 26, 28, 29) von dem Kontaktbereich (16, 17, 18, 19) wegführend einen die Kapillarwirkung verringernden Längsabschnitt (32) und/oder ein die Kapillarwirkung stoppendes Ende aufweist.

6. Leiterplatte (3) nach Anspruch 5,
**dadurch gekennzeichnet, dass**
der Längsabschnitt (32) durch eine Ausnehmung in der elektrisch leitfähigen Schicht gebildet ist, die eine größere Breitenabmessung aufweist als ein zum Kontaktbereich führender Längsabschnitt (31) der Kapillare (22, 24, 26, 28, 29).

7. Leiterplatte (3) nach einem der vorhergehenden Ansprüche,
**dadurch gekennzeichnet, dass**
die die Ausnehmung bildende Kapillare (22, 24, 26, 28, 29) eine kleinere Breitenabmessung quer zur Längserstreckung der Kapillare (22, 24, 26, 28, 29) aufweist als eine Dickenabmessung der elektrisch leitfähigen Schicht, insbesondere der Leiterbahn (21, 23, 25, 27, 36).

8. Leiterplatte (3) nach einem der vorhergehenden Ansprüche,
**dadurch gekennzeichnet, dass**
das Substrat (3, 50) im Bereich der Kapillare (22, 24, 26, 28, 29) luminenszierend ausgebildet ist, so dass eine von dem Substrat (3, 50) durch die Kapillare (22, 24, 26, 28, 29) tretende Lumineszenzstrahlung (45) in einer Aufsicht auf die Leiterplatte (3) erfasst werden kann.

9. Leiterplatte (3) nach einem der vorhergehenden Ansprüche,
**dadurch gekennzeichnet, dass**
das Substrat (3) im Bereich der Kapillare (22) eine von einem menschlichen Auge wahrnehmbare Farbe aufweist, die sich von einer Farbe der Leiterplatte, insbesondere von einer Farbe eines die Leiterplatte wenigstens teilweise bedeckenden Lötstopp-Lackes (33) unterscheidet.

10. Verfahren zum Verbinden wenigstens eines elektrischen Anschlusses (7, 8, 9, 11) eines Bauelements (5), insbesondere Ball-Grid-Array- oder Land-Grid-Array-Bauelements, mit einer elektrisch leitfähigen Schicht, insbesondere Leiterbahn (21, 23, 25, 27, 36) einer Leiterplatte (3), bei dem der wenigstens eine elektrische Anschluss (7, 8, 9, 11) auf einer der Leiterplatte (3) zugewandten Unterseite des Bauelements (5) ausgebildet ist, und der wenigstens eine elektrische Anschluss (7, 8, 9, 11) mit einem Lotmittel (12, 13, 14, 15), insbesondere Lotperle verbunden ist, wobei beim Verlöten des wenigstens einen elektrischen Anschlusses (7, 8, 9, 11) ein Teil des Lotmittels (12, 13, 14, 15) mittels Kapillarwirkung aus einem Raum zwischen dem Bauelement (5) und der Leiterplatte (3) herausgeführt wird, dass das herausgeführte Lotmittel (12') in einer Aufsicht auf die Leiterplatte (3), nämlich senkrecht auf die Leiterplatte (3), erfasst werden kann, wobei ein Vorhandensein des mittels der Kapillare (22, 24, 26, 28, 29) hinausgeführten Lotmittels (12') eine zwischen dem Bauelement (5) und der Leiterplatte befindliche, elektrisch leitfähige Lötstelle zwischen dem elektrischen Anschluss (7, 8, 9, 11) und der elektrisch leitfähigen Schicht repräsentiert,
**dadurch gekennzeichnet, dass**
das Lotmittel (12, 13, 14, 15) mittels Kapillarwirkung aus einem Raum zwischen dem Bauelement (5) und der Leiterplatte (3) seitlich des Bauelements (5) über eine Projektionslinie (30) einer Projektion des Bauelements (5) auf die Leiterplatte (3) hinausgeführt wird.

## Claims

1. Printed circuit board (3) comprising at least one substrate (4) and one electrically conductive layer which is connected to the substrate (4), wherein at least one conductor track (21, 23, 25, 27, 36) is formed by the electrically conductive layer, and the printed circuit board (3) has at least one component (5) with at least one electrical connection (7, 8, 9, 11), wherein the electrical connection (7, 8, 9, 11) is electrically connected to a contact region (16, 17, 18, 19) of the conductor track (21, 23, 25, 27, 36) by means of a solder (12, 13, 14, 15), wherein the electrical connection (7, 8, 9, 11) between the component (5) and the contact region (16, 17, 18, 19) extends at least partially between a component (5) and the substrate (4) of the printed circuit board (3), wherein the conductor track (21, 23, 25, 27) has, starting from the contact region (16, 17, 18, 19), a capillary (22, 24, 26, 28, 29) which guides the solder (12, 13, 14, 15), wherein the capillary (22, 24, 26, 28, 29) is designed to guide a portion of the solder (12, 13, 14, 15) out of a space between the component (5) and the printed circuit board (3) by means of a capillary effect in such a way that the solder (12') which has been guided out can be detected in a perpendicular plan view of the printed circuit board (3), so that the presence of the solder (12') which has been guided out by means of the capillary (22, 24, 26, 28, 29) represents an electrically conductive solder point, which is located between the component (5) and the printed circuit board, between the electrical connection (7, 8, 9, 11) and the electrically conductive layer,
**characterized in that**
the capillary (22, 24, 26, 28, 29) which guides the solder (12, 13, 14, 15) extends beyond a boundary (6) of the component (5), specifically a projection line (30) of a projection of the component (5) onto the printed circuit board (3), and in the process solder (12') is also guided laterally beyond the boundary (6) of the component (5).

2. Printed circuit board (3) according to Claim 1,
**characterized in that**
the capillary (22, 24, 26, 28, 29) is formed by a longitudinally extending depression or recess in the conductor track (21, 23, 25, 27, 36).

3. Printed circuit board (3) according to Claim 1 or 2,
**characterized in that**
the conductor track (21, 23, 25, 27, 36) is coated with a wetting agent which reduces a surface tension of the solder, in particular a solder resist (33), in a region which surrounds the capillary (22, 24, 26, 28, 29).

4. Printed circuit board (3) according to one of the preceding claims,
**characterized in that**
the capillary (22, 24, 26, 28, 29) extends only partially into the contact region (16, 17, 18, 19).

5. Printed circuit board (3) according to one of the preceding claims,
**characterized in that**
the capillary (22, 24, 26, 28, 29) has, leading away from the contact region (16, 17, 18, 19), a longitudinal section (32) which reduces the capillary effect and/or
an end which stops the capillary effect.

6. Printed circuit board (3) according to Claim 5,
**characterized in that**
the longitudinal section (32) is formed by a recess in the electrically conductive layer, which recess has a greater width dimension than a longitudinal section (31) of the capillary (22, 24, 26, 28, 29), which longitudinal section leads to the contact region.

7. Printed circuit board (3) according to one of the preceding claims,
**characterized in that**
the capillary (22, 24, 26, 28, 29) which forms the recess has a smaller width dimension transversely in relation to the longitudinal extent of the capillary (22, 24, 26, 28, 29) than a thickness dimension of the electrically conductive layer, in particular the conductor track (21, 23, 25, 27, 36).

8. Printed circuit board (3) according to one of the preceding claims,
**characterized in that**
the substrate (3, 50) is of luminescent design in the region of the capillary (22, 24, 26, 28, 29), so that a luminescence radiation (45) which passes from the substrate (3, 50) through the capillary (22, 24, 26, 28, 29) can be detected in a plan view of the printed circuit board (3).

9. Printed circuit board (3) according to one of the preceding claims,
**characterized in that**
the substrate (3) has, in the region of the capillary (22), a colour which can be perceived by the human eye and differs from a colour of the printed circuit board,
in particular from a colour of a solder resist (33) which at least partially covers the printed circuit board.

10. Method for connecting at least one electrical connection (7, 8, 9, 11) of a component (5), in particular ball grid array or land grid array component, to an electrically conductive layer, in particular conductor track (21, 23, 25, 27, 36) of a printed circuit board (3), in which method the at least one electrical connection (7, 8, 9, 11) is formed on a bottom side of the component (5), which bottom side faces the printed circuit board (3), and the at least one electrical connection (7, 8, 9, 11) is connected to a solder (12, 13, 14, 15), in particular solder ball, wherein, during soldering of the at least one electrical connection (7, 8, 9, 11), a portion of the solder (12, 13, 14, 15) is guided out of a space between the component (5) and the printed circuit board (3) by means of a capillary effect that the solder (12') which has been guided out can be detected in a plan view of the printed circuit board (3), specifically perpendicularly onto the printed circuit board (3), wherein the presence of the solder (12') which has been guided out by means of the capillary (22, 24, 26, 28, 29) represents an electrically conductive solder point, which is located between the component (5) and the printed circuit board, between the electrical connection (7, 8, 9, 11) and the electrically conductive layer,
**characterized in that**
the solder (12, 13, 14, 15) is guided out of a space between the component (5) and the printed circuit board (3) laterally in relation to the component (5) beyond a projection line (30) of a projection of the component (5) onto the printed circuit board (3) by means of a capillary effect.

## Revendications

1. Carte de circuits imprimés (3), comprenant au moins un substrat (4) et une couche électriquement conductrice reliée au substrat (4), la couche electriquement conductrice réalisant au moins une piste conductrice (21, 23, 25, 27, 36), et la carte de circuits imprimés (3) présentant au moins un composant (5) doté d'au moins une connexion electrique (7, 8, 9, 11), dans laquelle la connexion electrique (7, 8, 9, 11) est electriquement connectee a une zone de contact (16, 17, 18, 19) de la piste conductrice (21, 23, 25, 27, 36) au moyen d'un agent a braser (12, 13, 14, 15), la connexion électrique (7, 8, 9, 11) du composant (5) et de la zone de contact (16, 17, 18, 19) s'etendant au moins en partie entre un composant (5) et le substrat (4) de la carte de circuits imprimés (3), dans laquelle la piste conductrice (21, 23, 25, 27) présente en partant de la zone de contact (16, 17, 18, 19) un capillaire (22, 24, 26, 28, 29) guidant l'agent a braser (12, 13, 14, 15), le capillaire (22, 24, 26, 28, 29) étant réalisé pour faire sortir par capillarité une partie de l'agent à braser (12, 13, 14, 15) d'un espace entre le composant (5) et la carte de circuits imprimés (3) de telle sorte que l'agent a braser (12') sorti peut être détecté dans une vue verticale sur la carte de circuits imprimés (3), de sorte que la présence de l'agent a braser (12') sorti au moyen du capillaire (22, 24, 26, 28, 29) représente un point de brasage électriquement conducteur se trouvant entre le composant (5) et la carte de circuits imprimés entre la connexion électrique (7, 8, 9, 11) et la couche électriquement conductrice,
**caractérisée en ce que** le capillaire (22, 24, 26, 28, 29) guidant l'agent à braser (12, 13, 14, 15) s'etend au-delà d'une délimitation (6) du composant (5), notamment d'une ligne de projection (30) d'une projection du composant (5) sur la carte de circuits imprimés (3), et l'agent a braser (12') est alors évacué aussi latéralement au-delà de la délimitation (6) du composant (5).

2. Carte de circuits imprimés (3) selon la revendication 1, **caractérisée en ce que** le capillaire (22, 24, 26, 28, 29) est forme par un creux ou un évidement s'étendant dans la piste conductrice (21, 23, 25, 27, 36) dans le sens de la longueur.

3. Carte de circuits imprimés (3) selon la revendication 1 ou 2, **caractérisée en ce que** dans une zone entourant le capillaire (22, 24, 26, 28, 29), la piste conductrice (21, 23, 25, 27, 36) est recouverte d'un agent mouillant, en particulier d'un vernis épargne (33), qui réduit la tension superficielle de l'agent à braser.

4. Carte de circuits imprimés (3) selon l'une quelconque des revendications précédentes, **caracterisée en ce que** le capillaire (22, 24, 26, 28, 29) ne s'etend que partiellement dans la zone de contact (16, 17, 18, 19) .

5. Carte de circuits imprimés (3) selon l'une quelconque des revendications précédentes, **caractérisée en ce que** le capillaire (22, 24, 26, 28, 29) présente en s'éloignant de la zone de contact (16, 17, 18, 19) une partie longitudinale (32) diminuant la capillarité et/ou une extrémité arrêtant la capillarité.

6. Carte de circuits imprimés (3) selon la revendication 5, **caractérisée en ce que** la partie longitudinale (32) est formée par un évidement dans la couche électriquement conductrice qui présente une dimension de largeur supérieure à une partie longitudinale (31) du capillaire (22, 24, 26, 28, 29) menant a la zone de contact.

7. Carte de circuits imprimés (3) selon l'une quelconque des revendications précédentes, **caractérisée en ce que** le capillaire (22, 24, 26, 28, 29) formant l'evidement présente une dimension de largeur transversalement a l'extension longitudinale du capillaire (22, 24, 26, 28, 29) inférieure a une dimension d'épaisseur de la couche électriquement conductrice, en particulier de la piste conductrice (21, 23, 25, 27, 36).

8. Carte de circuits imprimés (3) selon l'une quelconque des revendications precedentes, **caractérisée en ce que** le substrat (3, 50) est réalisé de manière luminescente au niveau du capillaire (22, 24, 26, 28, 29) de sorte qu'un rayonnement luminescent (45) émanant du substrat (3, 50) à travers le capillaire (22, 24, 26, 28, 29) peut être détecté dans une vue de dessus de la carte de circuits imprimés (3).

9. Carte de circuits imprimés (3) selon l'une quelconque des revendications précédentes, **caractérisée en ce que** le substrat (3) présente au niveau du capillaire (22) une couleur perceptible pour l'œil humain qui est différente d'une couleur de la carte de circuits imprimés, en particulier d'une couleur d'un vernis épargne (33) recouvrant au moins partiellement la carte de circuits imprimés.

10. Procédé permettant de relier au moins une connexion électrique (7, 8, 9, 11) d'un composant (5), en particulier d'un composant de type grille matricielle a billes ou grille matricielle à plots, à une couche électriquement conductrice, en particulier a une piste conductrice (21, 23, 25, 27, 36) d'une carte de circuits imprimés (3), dans lequel ladite au moins une connexion électrique (7, 8, 9, 11) est réalisée sur une face inférieure du composant (5) tournée vers la carte de circuits imprimés (3), et ladite au moins une connexion électrique (7, 8, 9, 11) est reliée a un agent a braser (12, 13, 14, 15), en particulier a une perle de brasage, dans lequel, lors du brasage de ladite au moins une connexion électrique (7, 8, 9, 11), une partie de l'agent à braser (12, 13, 14, 15) est sortie par capillarité d'un espace entre le composant (5) et la carte de circuits imprimés (3) que l'agent à braser (12') sorti peut être détecté dans une vue sur la carte de circuits imprimés (3), notamment verticalement sur la carte de circuits imprimés (3), dans lequel la présence d'un agent a braser (12') sorti au moyen du capillaire (22, 24, 26, 28, 29) représente un point de brasage électriquement conducteur se trouvant entre le composant (5) et la carte de circuits imprimés entre la connexion électrique (7, 8, 9, 11) et la couche électriquement conductrice,
**caractérisé en ce que** l'agent à braser (12, 13, 14, 15) est sorti par capillarité d'un espace entre le composant (5) et la carte de circuits imprimés (3) latéralement par rapport au composant (5) par une ligne de projection (30) d'une projection du composant (5) sur la carte de circuits imprimés (3).
